# EUROPÄISCHE PATENTSCHRIFT

(11) **EP 3 086 126 B1**
(45) Veröffentlichungstag und Bekanntmachung des Hinweises auf die Patenterteilung: **16.12.2020**
(21) Anmeldenummer: 15164797.1
(22) Anmeldetag: 23.04.2015
(51) Int. Cl.: G01N 35/04, H03L 7/08

(54) **VERFAHREN ZUR BESTIMMUNG DER LAGE VON MESSPOSITIONEN IN EINEM MESSSYSTEM**
METHOD FOR DETERMINING THE POSITION OF MEASURING POSITIONS IN A MEASURING SYSTEM
PROCÉDÉ DE DÉTERMINATION DES POSITIONS DE MESURE DANS UN SYSTÈME DE MESURE

(43) Veröffentlichungstag der Anmeldung: 26.10.2016
(73) Patentinhaber: Siemens Healthcare Diagnostics Products GmbH, 35041 Marburg (DE)
(72) Erfinder: Steinebach, Wolfgang, 56414 Salz (DE)

(56) Entgegenhaltungen:
- EP-A1- 1 493 012
- EP-A1- 2 309 251
- EP-A1- 2 813 820
- WO-A1-89/06021
- WO-A1-2009/094761
- DE-A1- 4 313 399
- US-A- 4 508 450
- US-A1- 2001 055 812

## Beschreibung

Die vorliegende Erfindung liegt auf dem Gebiet der automatischen Analysegeräte insbesondere für die in vitro-Diagnostik und betrifft ein Verfahren zur Bestimmung der Lage einer Vielzahl von Messpositionen in einem Messsystem eines Analysegeräts sowie ein automatisches Analysegerät mit einer Steuerung für ein solches Verfahren.

Heutige Analysegeräte, wie sie routinemäßig in der Analytik, der Forensik, der Mikrobiologie und der klinischen Diagnostik Verwendung finden, sind in der Lage, eine Vielzahl von Nachweisreaktionen und Analysen mit einer Probe durchzuführen. Um eine Vielzahl von Untersuchungen automatisiert durchführen zu können, sind diverse automatisch arbeitende Vorrichtungen zum räumlichen Transfer von Messzellen, Reaktionsbehältern und Reagenzbehältern erforderlich, wie z.B. Transferarme mit Greiffunktion, Transportbänder oder drehbare Transporträder, sowie Vorrichtungen zum Transfer von Flüssigkeiten, wie z.B. Pipettiervorrichtungen. Die Geräte umfassen eine zentrale Steuereinheit, die mittels entsprechender Software dazu in der Lage ist, die Arbeitsschritte für die gewünschten Analysen weitgehend selbstständig zu planen und abzuarbeiten.

Viele der in derartigen automatisiert arbeitenden Analysegeräten verwendeten Analyseverfahren beruhen auf optischen Methoden. Die Bestimmung klinisch relevanter Parameter, wie zum Beispiel der Konzentration oder Aktivität eines Analyten, erfolgt vielfach, indem ein Teil einer Probe mit einem oder mehreren Testreagenzien in einem Reaktionsgefäß, welches auch die Messzelle sein kann, vermischt wird, wodurch eine biochemische Reaktion oder eine spezifische Bindungsreaktion, z.B. eine Antigen-Antikörper-Bindungsreaktion, in Gang gesetzt wird, die eine messbare Veränderung einer optischen oder anderen physikalischen Eigenschaft des Testansatzes bewirkt.

Neben der Spektrophotometrie und Turbidimetrie ist die Nephelometrie eine weit verbreitete Analysemethode. Entsprechende Analysegeräte weisen daher entsprechende photometrische Messvorrichtungen auf.

Eine photometrische Messvorrichtung umfasst mindestens eine Lichtquelle und mindestens einen Fotodetektor. Typischerweise ist die Anordnung von Lichtquelle und Fotodetektor so gewählt, dass das von der Lichtquelle ausgesandte Licht durch eine in einer Aufnahmeposition angeordnete Messzelle tritt und vom Lichtdetektor das Licht gemessen wird, das die Messzelle wieder verlässt.

Zunehmende Verbreitung finden Analysegeräte, bei denen entweder die photometrische Messvorrichtung relativ zu den Messzellen bewegbar ist oder bei denen die Messzellen relativ zur photometrischen Messvorrichtung bewegbar sind. Dies hat den Vorteil, dass mit einer Messvorrichtung eine Vielzahl von Proben gewissermaßen gleichzeitig untersucht werden kann, was den Probendurchsatz signifikant erhöht.

In EP-A1-2309251 ist eine Vorrichtung für die photometrische Untersuchung von Proben beschrieben, bei der an einer kreisförmigen Vorrichtung zur Aufnahme von Reaktionsgefäßen eine Vielzahl von stationären Messpositionen auf einer Kreisbahn angeordnet sind, während die photometrische Messvorrichtung auf einer horizontalen Kreisbahn um die vertikale Achse der Vorrichtung zur Aufnahme von Reaktionsgefäßen herum bewegbar ist. Alternativ ist es natürlich auch möglich, die photometrische Messvorrichtung stationär auszubilden und die Vorrichtung zur Aufnahme von Reaktionsgefäßen um ihre vertikale Achse zu drehen.

Bei derartigen photometrischen Systemen, bei denen die photometrische Messvorrichtung relativ zur Messzelle bewegt wird (oder umgekehrt), wird pro Umdrehung für jede der Messpositionen mindestens ein Messwert erfasst. Dabei muss für die korrekte Messwerterfassung sichergestellt sein, dass bei jeder Umdrehung jede Messposition festgelegt ist und von der photometrischen Messvorrichtung wiedergefunden wird. Dazu umfasst das System eine physische Referenzposition als Bezugspunkt, die eine Ausgangsstellung für die Relativbewegung zwischen Messvorrichtung und Messpositionen definiert. Bei bekannter, konstanter Rotationsgeschwindigkeit erfolgt dann die Bestimmung der einzelnen Messpositionen durch die Messung von Zeitabständen relativ zur physischen Referenzposition. Die gemessenen Zeitabstände können dann bestimmten Messpositionen zugeordnet werden. Eine physische Referenzposition kann beispielsweise durch eine Gabellichtschranke gebildet werden, die bei jeder Umdrehung einmal durchfahren wird.

Allerdings wird die Genauigkeit der Bestimmung der physischen Referenzposition in der Praxis durch verschiedene Faktoren eingeschränkt, wie z.B. durch Störungen oder Rauschen des Lichtschrankensignals oder durch eine nicht ausreichend homogene Bewegung der Messvorrichtung oder der Messpositionen, wie sie insbesondere bei der Ansteuerung durch Schrittmotoren häufig auftritt. Eine ungenaue Bestimmung der physischen Referenzposition führt in der folgenden Umdrehung zu einer ungenauen Bestimmung der Messpositionen, was wiederum eine verminderte Genauigkeit der Messwerterfassung zur Folge hat. Dies wiederum kann zu vollständig ungültigen Fehlmessungen führen, was den Durchsatz des Messsystems vermindert.

Aufgabe der Erfindung ist es also, ein Messsystem der eingangs genannten Art für ein automatisches Analysegerät derart zu verbessern, dass eine genaue Messwerterfassung sichergestellt ist.

Die Aufgabe wird erfindungsgemäß dadurch gelöst, dass ein Verfahren bereit gestellt wird, das eine genauere Bestimmung der Lage der Messpositionen in dem Messsystem ermöglicht, indem ausgehend von der bestimmten Lage der physischen Referenzposition mittels einer Phasenregelschleife die Lage einer virtuellen Referenzposition bestimmt wird.

Es wurde festgestellt, dass mit dem erfindungsgemäßen Verfahren die Anzahl von Fehlmessungen, die auf Positionsfehler zurückzuführen sind, vermindert wird. Gegenstand der vorliegenden Erfindung ist daher ein Verfahren zur Bestimmung der Lage einer Vielzahl von Messpositionen in einem Messsystem gemäß Anspruch 1.

Die physische Referenzposition wird bevorzugterweise durch ein optoelektronisches Sensorsystem, wie beispielsweise eine Einweg-Lichtschrankenvorrichtung, z.B. in Form einer Gabellichtschranke, gebildet. Dazu werden eine Lichtquelle und ein Fotodetektor gegenüberliegend auf der Messvorrichtung angeordnet, während auf der Vorrichtung zur Aufnahme von Reaktionsgefäßen an einer Stelle eine Blende vorgesehen wird, die das von der Lichtquelle auf den Fotodetektor fallende Lichtsignal zu unterbrechen vermag. Die Stelle, an der die Blende angeordnet ist, definiert die physische Referenzposition. Demzufolge besteht das physische Referenzsignal in diesem Fall aus einem unterbrochenen Lichtsignal, das durch eine Lichtschranke an der physischen Referenzposition generiert wird.

Alternativ ist die physische Referenzposition auch durch andere Sensorsysteme definierbar, beispielsweise durch Hall-Sensor- oder kapazitive Sensorsysteme.

Erfindungsgemäß wird das physische Referenzsignal an der physischen Referenzposition bei jeder Umdrehung der Vorrichtung zur Aufnahme von Reaktionsgefäßen um ihre vertikale Achse bzw. bei jeder Umdrehung der Messvorrichtung auf einer horizontalen Kreisbahn um die vertikale Achse der Vorrichtung zur Aufnahme von Reaktionsgefäßen gemessen, und es wird eine virtuelle Referenzposition mittels einer Phasenregelschleife bestimmt. Eine Phasenregelschleife (engl. Phase Locked Loop, PLL) ist eine elektronische Schaltungsanordnung, die über einen rückgekoppelten Regelkreis verfügt und im Allgemeinen zur Einstellung einer stabilen Phasenlage einer Position im Ablauf eines periodischen Vorgangs dient.

Eine für die erfindungsgemäße Bestimmung einer virtuellen Referenzposition geeignete Phasenregelschleife umfasst mindestens einen Phasendetektor, ein Schleifenfilter, wie z.B. ein Tiefpass-Filter, und einen Pulsgenerator. Grundsätzlich wird zwischen einem nicht-eingephasten Zustand der Phasenregelschleife ("unlocked PLL") und einem eingephasten oder eingeschwungenen Zustand der Phasenregelschleife ("locked PLL") unterschieden. Bei der Inbetriebnahme des Messsystems ist noch keine Phasenlage zwischen der Pulsfolge der tatsächlich gemessenen physischen Referenzsignale und einer vom Pulsgenerator erzeugten Pulssignalfolge bekannt, d.h. die Phasenregelschleife befindet sich im nicht-eingephasten Zustand. Erst wenn der Pulsgenerator eine korrigierte Pulssignalfolge erzeugt und an den Phasendetektor weiterleitet, deren Phasenabweichung eine definierte Mindestphasenabweichung unterschreitet, befindet sich die Phasenregelschleife im eingephasten Zustand.

Vorzugsweise ist die Phasenregelschleife so konfiguriert, dass der Phasendetektor im eingephasten Zustand die Abweichung des zuletzt gemessenen physischen Referenzsignals von der Phase einer vom Pulsgenerator erzeugten Pulssignalfolge ermittelt und an das Schleifenfilter weiterleitet.

Das Schleifenfilter leitet dann die Abweichung der zuletzt gemessenen Phase der physischen Referenzsignale von der Phase der vom Pulsgenerator erzeugten Pulssignalfolge zusammen mit einem vorbestimmten Korrekturfaktor an den Pulsgenerator weiter. Ferner ermittelt das Schleifenfilter den Mittelwert über N gemessene Perioden der physischen Referenzsignale und leitet diesen ebenfalls an den Pulsgenerator weiter.

Vorzugsweise passt das Schleifenfilter den Mittelwert über N gemessene Perioden der physischen Referenzsignale fortlaufend mit jeder Umdrehung an.

Im eingephasten Zustand erzeugt der Pulsgenerator dann eine Pulssignalfolge, deren Perioden dem Mittelwert über N gemessene Perioden der physischen Referenzsignale entsprechen und bei der die Phasenlage der Pulse mit dem Korrekturfaktor so korrigiert ist, dass die Abweichung zu der mittleren Phasenlage der zuletzt gemessenen Phasen der physischen Referenzsignale minimal ist. Diese Pulssignalfolge wird dann einerseits zur Regelung an den Phasendetektor zurückgeführt und andererseits als Ausgangspulsfolge ausgegeben. Jeder Puls der Ausgangspulsfolge entspricht der virtuellen Referenzposition der dazugehörigen Umdrehung.

Der Korrekturfaktor entspricht der Verstärkung oder Bedämpfung, mit der die Phasenregelschleife eine Phasenkorrektur vornimmt. Der Korrekturfaktor ist für jedes gegebene System empirisch in Simulationsexperimenten zu ermitteln. Alternativ kann der Korrekturfaktor auch mit Hilfe eines mathematischen Modells berechnet oder in einem Versuchsaufbau ermittelt werden.

Vorzugsweise ist die Phasenregelschleife ferner so konfiguriert, dass bei Inbetriebnahme des Messsystems, d.h. im noch nicht-eingephasten Zustand, der Phasendetektor zunächst die Periode zwischen einem ersten und einem zweiten physischen Referenzsignal misst und an den Pulsgenerator weiterleitet.

Der Pulsgenerator leitet im noch nicht-eingephasten Zustand die physischen Referenzsignale an den Phasendetektor weiter.

Der Phasendetektor ermittelt daraufhin die Abweichung des zuletzt gemessenen physischen Referenzsignals von der Phase der vom Pulsgenerator erzeugten Pulssignalfolge. Wenn dann die Abweichung kleiner als ein vorbestimmter Grenzwert ist, wird die Phasenregelschleife in den eingephasten Zustand umgeschaltet. Der Grenzwert ist für jedes gegebene System empirisch in Simulationsexperimenten zu ermitteln. Alternativ kann der Grenzwert auch mit Hilfe eines mathematischen Modells berechnet oder in einem Versuchsaufbau ermittelt werden.

Bevorzugterweise muss die Bedingung, dass die Abweichung kleiner als ein vorbestimmter Grenzwert ist, mindestens über eine Anzahl von zwei oder mehr (n ≥ 2) aufeinanderfolgenden Umdrehungen erfüllt sein.

Ein weiterer Gegenstand der vorliegenden Erfindung ist ein automatisches Analysegerät gemäß Anspruch 12.

Der integrierte Schaltkreis ist als Phasenregelschleife konfiguriert, die die virtuelle Referenzposition bestimmt. Bevorzugterweise ist der integrierte Schaltkreis ein digitaler integrierter Schaltkreis. Besonders bevorzugt wird ein Field Programmable Gate Array (FPGA) als digitaler integrierter Schaltkreis verwendet.

In einem bevorzugten Analysegerät umfasst das Messsystem eine photometrische Messvorrichtung. Eine photometrische Messvorrichtung kann eine oder mehrere spektrophotometrische Vorrichtungen und/oder eine oder mehrere nephelometrische Vorrichtungen aufweisen. Ein bevorzugtes Messystem ist in EP-A1-2309251 beschrieben.

Bevorzugterweise ist die physische Referenzposition an der kreisförmigen Vorrichtung zur Aufnahme von Reaktionsgefäßen aus einer Lichtschrankenvorrichtung gebildet. Dazu ist auf der Vorrichtung zur Aufnahme von Reaktionsgefäßen an einer Stelle beispielsweise eine Blende vorgesehen, die ein von einer an der Messvorrichtung angebrachten Lichtquelle auf einen ebenfalls an der Messvorrichtung angebrachten Fotodetektor fallendes Lichtsignal zu unterbrechen vermag. Die Stelle, an der die Blende angeordnet ist, definiert die physische Referenzposition.

### FIGURENBESCHREIBUNG

- FIG. 1: zeigt schematisch die Messdatenerfassung und Positionsberechung in einem Messsystem mit einem um einen stationären Probenaufnahmeteller rotierenden Photometer.
- FIG. 2: zeigt schematisch die Phasenregelschleife zur Reduzierung des Phasenrauschens bei der Bestimmung der Lage der Messpositionen in einem Messsystem gemäß FIG. 1

### BEISPIEL

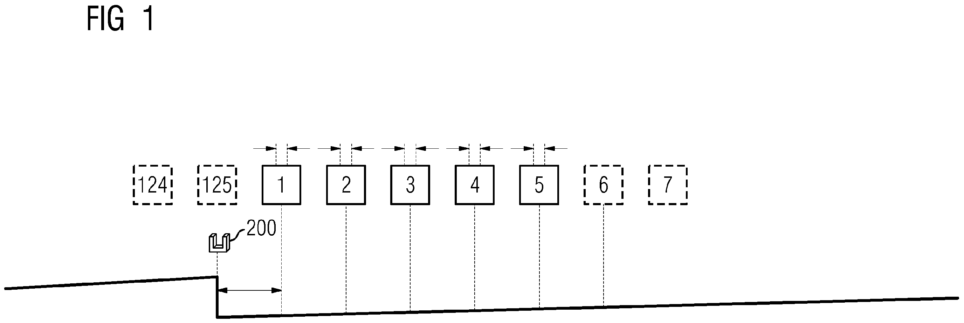

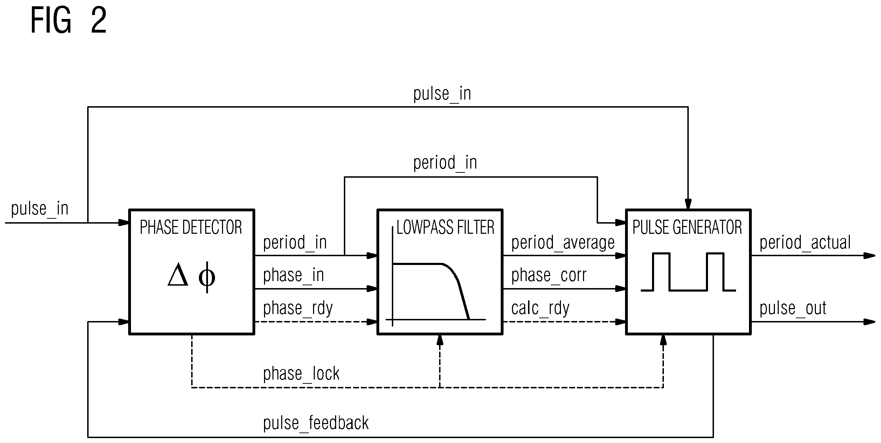

Anhand der FIG. 1 und 2 wird ein nicht näher dargestelltes automatisches Analysegerät erläutert, das ein Messsystem umfasst, bei dem ein Photometer einen kreisringförmigen Probenteller zur Aufnahme von 125 zylindrischen Reaktionsgefäßen mit konstanter Geschwindigkeit (2 Hz) umkreist.

FIG. 1 zeigt schematisch einen Teil der 125 vorhandenen Aufnahmepositionen, an denen das Photometer vorbeigeführt wird. Die physische Referenzposition ist gebildet aus einer Blende für eine Gabellichtschranke (200) und definiert den Bezugspunkt bzw. die Ausgangsstellung, von dem bzw. von der aus die Messpositionen 1-125 in bekannten Abständen angeordnet sind. Der bekannte Abstand zwischen der physischen Referenzposition und der ersten Messposition ist durch einen Doppelpfeil angedeutet. Die Messpositionen befinden sich innerhalb der Aufnahmepositionen für die Reaktionsgefäße, so dass eine optische Eigenschaft eines Reaktionsansatzes in einem Reaktionsgefäß, das in den Probenteller eingebracht wird, gemessen werden kann.

Für die korrekte Messwerterfassung muss sichergestellt sein, dass bei jeder Umdrehung jede Messposition korrekt wiedergefunden wird. Bei bekannter, konstanter Rotationsgeschwindigkeit erfolgt die Bestimmung der einzelnen Messpositionen durch die Messung von Zeitabständen relativ zur physischen Referenzposition. Die gemessenen Zeitabstände können dann den Messpositionen zugeordnet werden.

Allerdings ist die Genauigkeit der Bestimmung der physischen Referenzposition durch verschiedene Faktoren eingeschränkt, wie z.B. durch Störungen oder Rauschen des Lichtschrankensignals oder durch eine nicht ausreichend homogene Bewegung des Photometers. Eine ungenaue Bestimmung der physischen Referenzposition führt in der folgenden Umdrehung zu einer ungenauen Bestimmung der Messpositionen, was wiederum eine verminderte Genauigkeit der Messwerterfassung zur Folge hat. Dies wiederum kann zu vollständig ungültigen Fehlmessungen führen, was den Durchsatz des Messsystems vermindert.

Zur Vermeidung derartiger Fehlmessungen weist das hier beschriebene automatische Analysegerät einen digitalen integrierten Schaltkreis in Form eines FPGAs auf, dessen Teilfunktion als Phasenregelschleife konfiguriert ist, die eine virtuelle Referenzposition bestimmt.

FIG. 2 zeigt schematisch den Aufbau der Phasenregelschleife, die durch Programmierung eines FPGAs realisiert wurde. Steuernde Elemente sind mit gestrichelten Linien dargestellt. Informationsenthaltende Elemente sind mit durchgezogenen Linien dargestellt.

Das Eingangssignal (pulse_in) für diese Anordnung ist das physische Referenzsignal, das von der Gabellichtschranke immer dann erzeugt wird, wenn das Photometer die physische Referenzposition des Messsystems passiert.

Bei Inbetriebnahme des Messsystems, d.h. im nicht-eingephasten Zustand, wird im Phasendetektor (PHASE DETECTOR, ΔΦ) zunächst der zeitliche Abstand, also die Periode, zwischen einem ersten und einem zweiten physischen Referenzsignal durch einen Zähler ermittelt, und das Ergebnis (period_in) wird dem Schleifenfilter (LOWPASS FILTER) zur weiteren Verarbeitung bereit gestellt. Später, im eingephasten Zustand der Phasenregelschleife ("locked PLL") wird die aktuelle Phasenabweichung des letzten physischen Referenzsignals zu der vom Pulsgenerator (PULSE GENERATOR) generierten Pulssignalfolge (pulse_feedback) ermittelt, und auch dieses Ergebnis (phase_in) wird dem Schleifenfilter zur weiteren Verarbeitung bereit gestellt. Die Beendigung des Phasenvergleichs und der Ermittlung der Periodendauer (period_in) im Phasendetektor wird durch das Steuersignal phase_rdy signalisiert.

Das Schleifenfilter berechnet einen Mittelwert über N gemessene Perioden (period_average) der physischen Referenzsignale, um so einen mittleren Periodenwert zu ermitteln und an den Pulsgenerator weiterzuleiten. Ferner leitet das Schleifenfilter die mit einem vorbestimmten Korrekturfaktor multiplizierte aktuelle Phasenabweichung (phase_corr) an den Pulsgenerator weiter. Die Beendigung der Mittelwertermittlung über N gemessene Perioden im Schleifenfilter wird durch das Steuersignal calc_rdy signalisiert.

Der Korrekturfaktor entspricht der Verstärkung (oder Bedämpfung), mit der die Phasenregelschleife anschließend eine Phasenkorrektur vornimmt. Kleine Korrekturfaktoren bewirken ein träges System, in welchem die Differenz der Phasenlage von Ausgangspuls (pulse_out) zum Eingangspuls (pulse_in) nur langsam gegen Null ausgeregelt wird. Die Filterwirkung ist dabei hoch, d.h. die Auslenkung der einzelnen Pulse in ihrer zeitlichen Lage gering. Große Korrekturfaktoren bewirken ein schnelleres Ausregeln der Phasendifferenz bei gleichzeitig geringerer Filterwirkung und somit erhöhter Pulsauslenkung. Für das hier in der Praxis realisierte System wurde der Korrekturfaktor auf Basis von Simulationen auf 1/2⁶ (0,015625) bestimmt.

Das verwendete Schleifenfilter besitzt die Eigenschaft, die Filtertiefe dynamisch anzupassen, d.h. bei Inbetriebnahme des Messsystems wird als Filterergebnis die Filtertiefe N fortlaufend angepasst, beginnend mit dem Ergebnis aus zunächst einer Umdrehung, einem gemittelten Ergebnis aus zwei Umdrehungen u.s.w. Um bei der Berechnung des Mittelwertes den Schaltungsaufwand klein zu halten, wurde die dynamische Mittelwertbildung auf N=2^{k} mit k= 0, 1, ... 10 begrenzt. Dadurch kann die Mittelwertbildung durch eine einfache Shift-Operation des Binärwertes durchgeführt werden.

Der Pulsgenerator erzeugt im eingephasten Zustand eine Pulssignalfolge. Die Periode dieser Pulssignalfolge entspricht dem Mittelwert über N gemessene Perioden der physischen Referenzsignale. Die Phasenlage und somit die genaue Pulsposition ergibt sich ebenfalls aus den vorangegangenen Pulspositionen. Eine Phasenabweichung aus einer Umdrehung führt unmittelbar zu einer über den Korrekturfaktor einstellbaren Phasenkorrektur. Zur Überwachung der Umdrehungsdauer wird der zeitliche Abstand der letzten Pulse einem übergeordneten Rechner weitergeleitet (period_actual) .

Unmittelbar nach Inbetriebnahme des Messsystems ist noch keine Phasenlage zwischen der Pulsfolge der tatsächlich gemessenen physischen Referenzsignale und einer vom Pulsgenerator erzeugten Pulssignalfolge bekannt. Daher werden die ersten Pulse aus den tatsächlich gemessenen physischen Referenzsignalen (pulse_in) direkt abgeleitet und an den Ausgang der Anordnung (pulse_out) und an den Phasendetektor (pulse_feedback) gegeben. Nachdem die vom Phasendetektor ermittelten Phasenabweichungen über mehrere Messungen einen vorgegebenen Grenzwert unterschreiten, wird das Steuersignal phase_lock eingeschaltet, d.h. die Anordnung geht in den eingephasten Zustand ("locked PLL") über. Dadurch wird die dynamische Filterung des Tiefpass-Filters aktiviert und die Pulserzeugung im Pulsgenerator auf die gefilterte Pulsperiode und die Phasenkorrektur umgeschaltet.

Jeder Puls der Ausgangspulsfolge (pulse_out) im eingephasten Zustand entspricht der virtuellen Referenzposition der dazugehörigen Umdrehung. Die Ausgangspulsfolge wird an eine übergeordnete Berechnungseinheit weitergeleitet, die dann anhand der virtuellen Referenzposition die Lage der Messpositionen in dem photometrischen Messsystem bestimmt.

## Patentansprüche

1. Verfahren zur Bestimmung der Lage einer Vielzahl von Messpositionen in einem Messsystem, das Messsystem umfassend
a. eine kreisförmige Vorrichtung zur Aufnahme von Reaktionsgefäßen, die eine Vielzahl von auf einer Kreisbahn angeordneten Messpositionen und eine physische Referenzposition aufweist, wobei jede Messposition in bekanntem Abstand von der physischen Referenzposition angeordnet ist, und
b. eine Messvorrichtung,
wobei entweder die Vorrichtung zur Aufnahme von Reaktionsgefäßen um ihre vertikale Achse drehbar ist oder die Messvorrichtung auf einer horizontalen Kreisbahn um die vertikale Achse der Vorrichtung zur Aufnahme von Reaktionsgefäßen herum bewegbar ist,
das Verfahren umfassend die folgenden Schritte:
i. Drehen der Vorrichtung zur Aufnahme von Reaktionsgefäßen um ihre vertikale Achse oder Bewegen der Messvorrichtung auf einer horizontalen Kreisbahn um die vertikale Achse der Vorrichtung zur Aufnahme von Reaktionsgefäßen mit jeweils konstanter Drehzahl;
ii. Messen eines physischen Referenzsignals an der physischen Referenzposition bei jeder Umdrehung; **gekennzeichnet durch** die weiteren Schritte
iii. Bestimmen einer virtuellen Referenzposition mittels einer Phasenregelschleife, die eine Ausgangspulsfolge ausgibt, wobei jeder Puls der Ausgangspulsfolge der virtuellen Referenzposition der dazugehörigen Umdrehung entspricht und
iv. Berechnen der Lage der Messpositionen anhand von vorbestimmten Zeitabständen von der virtuellen Referenzposition.

2. Verfahren gemäß Anspruch 1, wobei das physische Referenzsignal aus einem unterbrochenen Lichtsignal besteht, das durch eine Lichtschranke an der physischen Referenzposition generiert wird.

3. Verfahren gemäß einem der vorhergehenden Ansprüche, wobei die Phasenregelschleife zur Bestimmung der virtuellen Referenzposition einen Phasendetektor, ein Schleifenfilter und einen Pulsgenerator umfasst.

4. Verfahren gemäß Anspruch 3, wobei der Phasendetektor im eingephasten Zustand die Abweichung des zuletzt gemessenen physischen Referenzsignals von der Phase einer vom Pulsgenerator erzeugten Pulssignalfolge ermittelt und an das Schleifenfilter weiterleitet.

5. Verfahren gemäß Anspruch 4, wobei das Schleifenfilter die Abweichung der zuletzt gemessenen Phase der physischen Referenzsignale von der Phase der vom Pulsgenerator erzeugten Pulssignalfolge und einen vorbestimmten Korrekturfaktor an den Pulsgenerator weiterleitet und ferner den Mittelwert über N gemessene Perioden der physischen Referenzsignale ermittelt und ebenfalls an den Pulsgenerator weiterleitet.

6. Verfahren gemäß Anspruch 5, wobei der Pulsgenerator dann eine Pulssignalfolge erzeugt, deren Perioden dem Mittelwert über N gemessene Perioden der physischen Referenzsignale entsprechen und bei der die Phasenlage der Pulse mit dem Korrekturfaktor so korrigiert ist, dass die Abweichung zu der mittleren Phasenlage der zuletzt gemessenen Phasen der physischen Referenzsignale minimal ist, und dann die Pulssignalfolge einerseits an den Phasendetektor weiterleitet und andererseits als Ausgangspulsfolge ausgibt, wobei jeder Puls der Ausgangspulsfolge der virtuellen Referenzposition der dazugehörigen Umdrehung entspricht.

7. Verfahren gemäß Anspruch 5, wobei das Schleifenfilter den Mittelwert über N gemessene Perioden der physischen Referenzsignale fortlaufend mit jeder Umdrehung anpasst.

8. Verfahren gemäß einem der vorhergehenden Ansprüche, wobei der Phasendetektor bei Inbetriebnahme des Messsystems, im noch nicht-eingephasten Zustand, zunächst die Periode zwischen einem ersten und einem zweiten physischen Referenzsignal misst und an den Pulsgenerator weiterleitet.

9. Verfahren gemäß Anspruch 8, wobei der Pulsgenerator im noch nicht-eingephasten Zustand die physischen Referenzsignale an den Phasendetektor weiterleitet.

10. Verfahren gemäß Anspruch 9, wobei der Phasendetektor die Abweichung des zuletzt gemessenen physischen Referenzsignals von der Phase der vom Pulsgenerator erzeugten Pulssignalfolge ermittelt und dann, wenn die Abweichung kleiner als ein vorbestimmter Grenzwert ist, die Phasenregelschleife in den eingephasten Zustand umgeschaltet wird.

11. Verfahren gemäß Anspruch 10, wobei die Bedingung, dass die Abweichung kleiner als ein vorbestimmter Grenzwert ist, mindestens über eine Anzahl n ≥ 2 aufeinanderfolgender Umdrehungen erfüllt sein muss.

12. Automatisches Analysegerät mit einem Messsystem, das Messsystem umfassend
a. eine kreisförmige Vorrichtung zur Aufnahme von Reaktionsgefäßen, die eine Vielzahl von auf einer Kreisbahn angeordneten Messpositionen und eine physische Referenzposition aufweist, wobei jede Messposition in bekanntem Abstand von der physischen Referenzposition angeordnet ist, und
b. eine Messvorrichtung,
wobei entweder die Vorrichtung zur Aufnahme von Reaktionsgefäßen um ihre vertikale Achse drehbar ist oder die Messvorrichtung auf einer horizontalen Kreisbahn um die vertikale Achse der Vorrichtung zur Aufnahme von Reaktionsgefäßen herum bewegbar ist,
**dadurch gekennzeichnet, dass** das Analysegerät ferner eine Steuerungseinheit und einen integrierten Schaltkreis aufweist, wobei die Steuerungseinheit so konfiguriert ist, dass sie ein Verfahren mit den folgenden Schritten steuert:
i. Drehen der Vorrichtung zur Aufnahme von Reaktionsgefäßen um ihre vertikale Achse oder Bewegen der Messvorrichtung auf einer horizontalen Kreisbahn um die vertikale Achse der Vorrichtung zur Aufnahme von Reaktionsgefäßen mit jeweils konstanter Drehzahl;
ii. Messen eines Referenzsignals an der physischen Referenzposition bei jeder Umdrehung;
**dadurch gekennzeichnet, dass** der integrierte Schaltkreis als Phasenregelschleife konfiguriert ist, die eine Ausgangspulsfolge ausgibt, wobei jeder Puls der Ausgangspulsfolge der virtuellen Referenzposition der dazugehörigen Umdrehung entspricht, und dass die Lage der Messpositionen anhand von vorbestimmten Zeitabständen von der virtuellen Referenzposition berechnet werden.

13. Automatisches Analysegerät gemäß Anspruch 12, wobei der integrierte Schaltkreis ein digitaler integrierter Schaltkreis und besonders bevorzugt ein Field Programmable Gate Array (FPGA) ist.

14. Automatisches Analysegerät gemäß einem der Ansprüche 12 und 13, wobei die Messvorrichtung eine photometrische Messvorrichtung ist.

15. Automatisches Analysegerät gemäß einem der Ansprüche 10 bis 14, wobei die physische Referenzposition aus einer Lichtschrankenvorrichtung gebildet ist.

## Claims

1. Method for determining the position of a multiplicity of measurement locations in a measurement system, the measurement system comprising
a. a circular apparatus for receiving reaction vessels, which has a multiplicity of measurement locations arranged on a circular trajectory and a physical reference location, wherein each measurement location is arranged at a known distance from the physical reference location, and
b. a measurement apparatus,
wherein either the apparatus for receiving reaction vessels is rotatable about the vertical axis thereof or the measurement apparatus is moveable on a horizontal circular trajectory about the vertical axis of the apparatus for receiving reaction vessels,
the method comprising the following steps:
i. rotating the apparatus for receiving reaction vessels about the vertical axis thereof or moving the measurement apparatus on a horizontal circular trajectory about the vertical axis of the apparatus for receiving reaction vessels with a constant rotational speed in each case;
ii. measuring a physical reference signal at the physical reference location during each revolution; **characterized by** the further steps of
iii. determining a virtual reference location by means of a phase locked loop which outputs an output pulse sequence, wherein each pulse of the output pulse sequence corresponds to the virtual reference location of the associated revolution, and
iv. calculating the position of the measurement locations on the basis of predetermined time intervals from the virtual reference location.

2. Method according to Claim 1, wherein the physical reference signal consists of an interrupted light signal, which is generated by a photoelectric sensor at the physical reference location.

3. Method according to either one of the preceding claims, wherein the phase locked loop for determining the virtual reference location comprises a phase detector, a loop filter and a pulse generator.

4. Method according to Claim 3, wherein the phase detector, in the locked state, establishes the deviation of the last-measured physical reference signal from the phase of a pulse signal sequence generated by the pulse generator and forwards this to the loop filter.

5. Method according to Claim 4, wherein the loop filter forwards the deviation of the last-measured phase of the physical reference signals from the phase of the pulse signal sequence generated by the pulse generator and a predetermined correction factor to the pulse generator and furthermore establishes the mean value over N measured periods of the physical reference signals and likewise forwards this to the pulse generator.

6. Method according to Claim 5, wherein the pulse generator then generates a pulse signal sequence, the periods of which correspond to the mean value over N measured periods of the physical reference signals and in which the phase angle of the pulses is corrected by the correction factor in such a way that the deviation from the mean phase angle of the last-measured phases of the physical reference signals is minimal, and it then, firstly, forwards the pulse signal sequence to the phase detector and, secondly, outputs this as an output pulse sequence, wherein each pulse of the output pulse sequence corresponds to the virtual reference location of the associated revolution.

7. Method according to Claim 5, wherein the loop filter adapts the mean value over N measured periods of the physical reference signals continuously with each revolution.

8. Method according to any one of the preceding claims, wherein the phase detector initially measures the period between a first and a second physical reference signal and forwards this to the pulse generator during the start up of the measurement system, while it is still in the unlocked state.

9. Method according to Claim 8, wherein the pulse generator, while it is still in the unlocked state, forwards the physical reference signals to the phase detector.

10. Method according to Claim 9, wherein the phase detector establishes the deviation of the last-measured physical reference signal from the phase of the pulse signal sequence generated by the pulse generator and the phase locked loop is then switched over into the locked state when the deviation is less than a predetermined threshold value.

11. Method according to Claim 10, wherein the condition that the deviation is less than a predetermined threshold value must be satisfied at least over a number n ≥ 2 of successive revolutions.

12. Automated analysis device with a measurement system, the measurement system comprising
a. a circular apparatus for receiving reaction vessels, which has a multiplicity of measurement locations arranged on a circular trajectory and a physical reference location, wherein each measurement location is arranged at a known distance from the physical reference location, and
b. a measurement apparatus,
wherein either the apparatus for receiving reaction vessels is rotatable about the vertical axis thereof or the measurement apparatus is moveable on a horizontal circular trajectory about the vertical axis of the apparatus for receiving reaction vessels,
**characterized in that** the analysis device furthermore has a control unit and an integrated circuit, wherein the control unit is configured in such a way that it controls a method comprising the following steps:
i. rotating the apparatus for receiving reaction vessels about the vertical axis thereof or moving the measurement apparatus on a horizontal circular trajectory about the vertical axis of the apparatus for receiving reaction vessels with a constant rotational speed in each case;
ii. measuring a reference signal at the physical reference location during each rotation;
**characterized in that** the integrated circuit is configured as a phase locked loop which outputs an output pulse sequence, wherein each pulse of the output pulse sequence corresponds to the virtual reference location of the associated revolution, and **in that** the position of the measurement locations is calculated on the basis of predetermined time intervals from the virtual reference location.

13. Automated analysis device according to Claim 12, wherein the integrated circuit is a digital integrated circuit and particularly preferably a field programmable gate array (FPGA).

14. Automated analysis device according to either one of Claims 12 and 13, wherein the measurement apparatus is a photometric measurement apparatus.

15. Automated analysis device according to any one of Claims 10 to 14, wherein the physical reference location is formed from a photoelectric sensor apparatus.

## Revendications

1. Procédé de détermination de l'implantation d'une pluralité de positions de mesure dans un système de mesure, le système de mesure comprenant
a. une installation circulaire de réception de récipients de réaction, qui a une pluralité de positions de mesure, disposées sur un tracé circulaire, et une position de référence physique, chaque position de mesure étant disposée à une distance connue de la position de référence physique, et
b. une installation de mesure,
dans lequel, soit l'installation de réception de récipients de réaction peut tourner autour de son axe vertical, soit l'installation de mesure peut être déplacée sur une trajectoire horizontale autour de l'axe vertical de l'installation de réception de récipients de réaction,
le procédé comprenant les stades suivants :
i. rotation de l'installation de réception de récipients de réaction autour de son axe vertical ou déplacement de l'installation de mesure sur une trajectoire horizontale autour de l'axe vertical de l'installation de réception de récipients de réaction à, respectivement, un nombre de tours constant ;
ii. mesure d'un signal de référence physique à la position de référence physique à chaque tour ;
**caractérisée par** les autres stades
iii. détermination d'une position de référence virtuelle au moyen d'une boucle de réglage de phase, qui émet un train d'impulsions de sortie, chaque impulsion du train d'impulsions de sortie correspondant à la position de référence virtuelle du tour, qui y est associé et
iv. calcul de l'implantation des positions de mesure à l'aide de distances dans le temps, déterminées à l'avance, à la position de référence virtuelle.

2. Procédé suivant la revendication 1, dans lequel le signal de référence physique consiste en un signal lumineux interrompu, qui est produit par une cellule photoélectrique à la position de référence physique.

3. Procédé suivant l'une des revendications précédentes, dans lequel la boucle de réglage de phase pour la détermination d'une position de référence virtuelle comprend un détecteur de phase, un filtre à boucle et un générateur d'impulsions.

4. Procédé suivant la revendication 3, dans lequel le détecteur de phase détermine, dans l'état de mise en phase, l'écart du signal de référence physique mesuré en dernier à la phase d'un train de signaux d'impulsion produit par le générateur d'impulsions et l'achemine au filtre à boucle.

5. Procédé suivant la revendication 4, dans lequel le filtre à boucle achemine au générateur d'impulsions l'écart de la phase mesurée en dernier des signaux de référence physiques à la phase du train de signaux d'impulsion produit par le générateur d'impulsions et un facteur de correction déterminé à l'avance et détermine, en outre, la valeur moyenne sur N périodes mesurées des signaux de référence physiques et l'achemine également au générateur d'impulsions.

6. Procédé suivant la revendication 5, dans lequel le générateur d'impulsions produit ensuite un train de signaux d'impulsion, dont les période correspondent à la valeur moyenne sur N périodes mesurées des signaux de référence physiques, et dans lequel l'implantation en phase des impulsions est corrigée par le facteur de correction, de manière à minimiser l'écart à l'implantation moyenne en phase des phases, mesurées en dernier des signaux de référence physiques et, ensuite, achemine le train de signaux d'impulsion, d'une part au détecteur de phase, et d'autre part l'émet comme train d'impulsions de sortie, chaque impulsion du train d'impulsions de sortie correspondant à la position de référence virtuelle du tour, qui lui est associé.

7. Procédé suivant la revendication 5, dans lequel le filtre à boucle adapte la valeur moyenne sur N périodes mesurées des signaux de référence physiques en continu à chaque tour.

8. Procédé suivant l'une des revendications précédentes, dans lequel le détecteur de phase, lors de la mise en service du système de mesure, mesure, dans l'état non encore mis en phase, d'abord la période entre un premier et un deuxième signal de référence physique et l'achemine au générateur d'impulsions.

9. Procédé suivant la revendication 8, dans lequel le générateur d'impulsions achemine, dans l'état non encore mis en phase, les signaux de référence physiques au détecteur de phase.

10. Procédé suivant la revendication 9, dans lequel le détecteur de phase détermine l'écart du signal de référence physique, mesuré en dernier, à la phase du train de signaux d'impulsion produit par le générateur d'impulsions et, ensuite, si l'écart est plus petit qu'une valeur limite déterminée à l'avance, la boucle de réglage de phase est commutée dans l'état de mise en phase.

11. Procédé suivant la revendication 10, dans lequel la condition, suivant laquelle l'écart est plus petit qu'une valeur limite déterminée à l'avance, doit être satisfaite, au moins sur un nombre n ≥ 2 de tours successifs.

12. Appareil d'analyse automatique ayant un système de mesure, le système de mesure comprenant
a. une installation circulaire de réception de récipients de réaction, qui a une pluralité de positions de mesure, disposées sur un tracé circulaire, et une position de référence physique, chaque position de mesure étant disposée à une distance connue de la position de référence physique, et
b. une installation de mesure,
dans lequel, soit l'installation de réception de récipients de réaction peut tourner autour de son axe vertical, soit l'installation de mesure peut être déplacée sur une trajectoire horizontale autour de l'axe vertical de l'installation de réception de récipients de réaction,
**caractérisé en ce que** l'appareil d'analyse a, en outre, une unité de commande et un circuit intégré, l'unité de commande étant configurée de manière à commander un procédé ayant les stades suivants :
i. rotation de l'installation de réception de récipients de réaction autour de son axe vertical ou déplacement de l'installation de mesure sur une trajectoire horizontale autour de l'axe vertical à l'installation de réception de récipients de réaction à, respectivement, un nombre de tours constant ;
ii. mesure d'un signal de référence physique à la position de référence physique à chaque tour ;
**caractérisé en ce que** le circuit intégré est configuré en boucle de réglage de phase, qui émet un train d'impulsions de sortie, chaque impulsion du train d'impulsions de sortie correspondant à la position de référence virtuelle du tour, qui lui est associé, et **en ce que** l'implantation des positions de mesure est calculée à l'aide de distances dans le temps, déterminées à l'avance, à la position de référence virtuelle.

13. Appareil d'analyse automatique suivant la revendication 12, dans lequel le circuit intégré est un circuit intégré numérique et, de préférence, est un field programmable gâte array (FPGA).

14. Appareil d'analyse automatique suivant l'une des revendications 12 et 13, dans lequel l'installation de mesure est une installation de mesure photométrique.

15. Appareil d'analyse automatique suivant l'une des revendications 10 à 14, dans lequel la position de référence physique est formée d'une installation à cellule photoélectrique.
